# EUROPEAN PATENT APPLICATION

(11) **EP 2 838 117 A1**
(43) Date of publication of application: **18.02.2015**
(21) Application number: 14180652.1
(22) Date of filing: 12.08.2014
(51) Int. Cl.: H01L 25/075, H01L 25/16

(54) **LED lighting device**

(30) Priority: 16.08.2013 TW 102129462
(71) Applicant: Brightek Optoelectronic (Shenzhen) Co., Ltd., 518125 Shenzhen (CN); Brightek Optoelectronic Co., Ltd., 330 Taoyuan City, Taoyuan County (TW)
(72) Inventor: Huang, Chien-Chung, 330 Taoyuan City, Taoyuan County (TW); Wu, Chih-Ming, 330 Taoyuan City, Taoyuan County (TW); Chen, Yi Hsun, 106 Taipei City (TW); Chang, Yen Hsiung, 330 Taoyuan City, Taoyuan County (TW); Tsai, Yu Tsung, 330 Taoyuan City, Taoyuan County (TW)
(74) Representative: Viering, Jentschura & Partner Patent- und Rechtsanwälte

(57) **Abstract**

An LED lighting device includes a circuit board (1), an LED die module (2), an LED driving component (31), and a translucent packaged body (4). The circuit board (1) has a thermally conductive substrate (11), an electrically conductive layer (12), and two electrodes (13) disposed on the thermally conductive substrate (11). The electrically conductive layer (12) is disposed on a first surface (111) of the thermally conductive substrate (11), and is electrically connected to the electrodes (13). The LED die module (2) and the LED driving component (31) are welded on the electrically conductive layer (12) to establish an electrical connection therebetween. The packaged body (4) is integrally formed as one body on the first surface (111) to cover the LED die module (2) and the LED driving component (31). The LED die module (2) is packaged in the packaged body (4). Thus, the two electrodes (13) are configured to electrically connect to an external power source (200) for directly turning on the LED die module (2).

## Description

### BACKGROUND OF THE INVENTION

### 1. Field of the Invention

The instant disclosure relates to a lighting device; in particular, to an LED lighting device for electrically connecting to and directly using an external power source.

### 2. Description of Related Art

In recent years, the application of LED has been increasingly widespread, and as technology continuously upgrades, a high-power and high-brightness LED has been developed to replace traditional lighting.

The conventional LED lighting device is formed by mounting the packaged LED chip and the packaged LED driving chip on the circuit board. Alternatively, when the LED die is mounted on the circuit board, a supporting layer is required to form on the circuit board, and the supporting layer has several accommodating slots for receiving the LED dies. Each LED die is electrically connected to a portion of the circuit board that is arranged inside the respective accommodating slot by wiring.

However, the conventional LED lighting device is far too complicated to reduce cost, thereby hindering the replacement of the traditional lighting.

To achieve the abovementioned improvement, the inventors strive via industrial experience and academic research to present the instant disclosure, which can provide additional improvement as mentioned above.

### SUMMARY OF THE INVENTION

One embodiment of the instant disclosure provides an LED lighting device for covering the LED die module and the LED driving component by the packaged body.

The LED lighting device provided by the instant disclosure comprises: a circuit board having a thermally conductive substrate, an electrically conductive layer, and two electrodes disposed on the thermally conductive substrate, wherein the thermally conductive substrate has a first surface and an opposite second surface, the electrically conductive layer disposed on the first surface, the two electrodes electrically connect to the electrically conductive layer; an LED die module welded on the electrically conductive layer; an LED driving component welded on the electrically conductive layer, wherein the LED driving component electrically connects to the LED die module and the electrodes via the electrically conductive layer; and a translucent packaged body formed as one body, wherein the packaged body is integrally formed on the first surface to cover the LED die module and the LED driving component, and the LED die module is packaged in the packaged body; wherein the two electrodes are configured to electrically connect to an external power source for transmitting electrical power generated from the external power source through the electrically conductive layer and the LED driving component to turn on the LED die module.

Preferably, the LED lighting device further comprises a rectifying component and a power component, which are welded on the electrically conductive layer. The packaged body covers the rectifying component, the power component, and a portion of the electrically conductive layer not welded to the LED die module, the LED driving component, the rectifying component, and the power component. The two electrodes are configured to electrically connect to a commercial socket for transmitting AC power generated from the commercial socket through the electrically conductive layer, the LED driving component, the rectifying component, and the power component in order to turn on the LED die module.

The LED lighting device provided by the instant disclosure comprises: a circuit board having a thermally conductive substrate, an electrically conductive layer, and two electrodes disposed on the thermally conductive substrate, wherein the thermally conductive substrate has a first surface and an opposite second surface, the electrically conductive layer disposed on the first surface, the two electrodes electrically connect to the electrically conductive layer; an LED die module welded on the electrically conductive layer; an electronic component being a die, the electronic component welded on the electrically conductive layer, wherein the electronic component electrically connects to the LED die module and the electrodes via the electrically conductive layer; and a translucent packaged body formed as one body, wherein the packaged body is integrally formed on the first surface to cover the LED die module and the electronic component, wherein the LED die module and the electronic component are packaged in the packaged body.

Based on the above, the LED lighting device of the instant disclosure, the packaged body can package the LED die module and protect the LED die module and the electronic component (e.g., the LED driving component), thereby reducing the cost of the LED lighting device. The LED lighting device can electrically connect to and directly use the external power source for lighting.

In order to further appreciate the characteristics and technical contents of the instant disclosure, references are hereunder made to the detailed descriptions and appended drawings in connection with the instant disclosure. However, the appended drawings are merely shown for exemplary purposes, rather than being used to restrict the scope of the instant disclosure.

### BRIEF DESCRIPTION OF THE DRAWINGS

Fig. 1 is a perspective view showing an LED lighting device according to a first embodiment of the instant disclosure;
Fig. 2 is a side view showing the LED lighting device of Fig. 1;
Fig. 3 is a perspective view showing the LED lighting device before the packaged body is formed;
Fig. 4 is a perspective view showing the LED lighting device as the fluorescent powders are added;
Fig. 5 is a side view showing the usage of the first embodiment of the instant disclosure;
Fig. 6 is a side view showing an alternative state of the first embodiment of the instant disclosure;
Fig. 7 is a side view showing another alternative state of the first embodiment of the instant disclosure;
Fig. 8 is a perspective view showing the LED lighting device according to a second embodiment of the instant disclosure;
Fig. 9 is a perspective view showing the LED lighting device according to a third embodiment of the instant disclosure;
Fig. 10 is a perspective view showing the LED lighting device according to the third embodiment of the instant disclosure from another perspective angle;
Fig. 11 is a cross-sectional view showing the LED lighting device of Fig. 9; and
Fig. 12 is a perspective view showing the usage of the third embodiment of the instant disclosure.

### DETAILED DESCRIPTION OF THE PREFERRED EMBODIMENTS

### [First Embodiment]

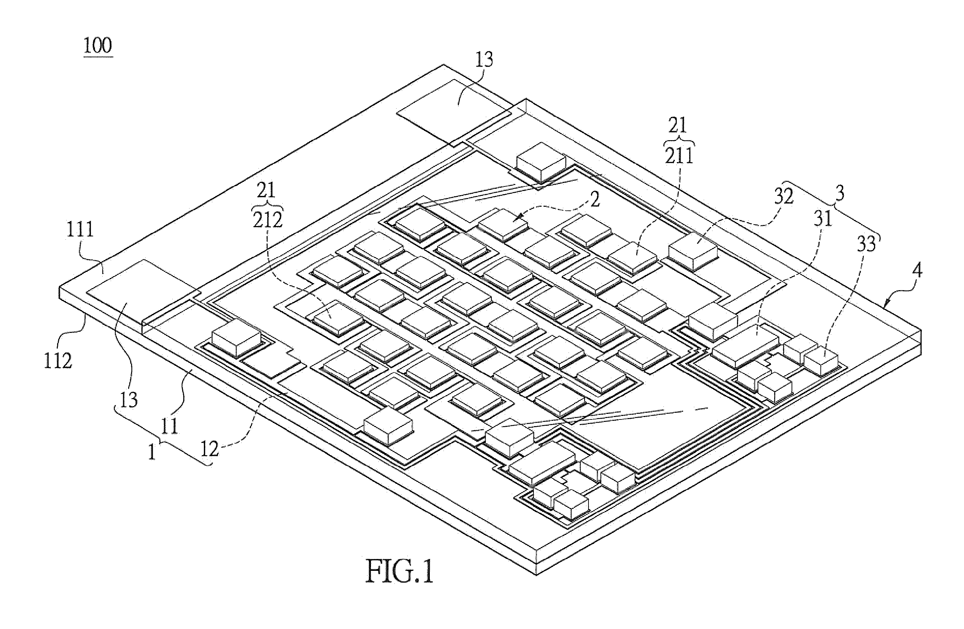

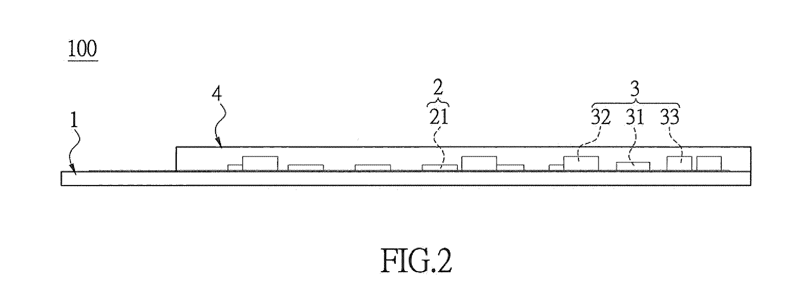

Please refer to Figs. 1 through 7, which show a first embodiment of the instant disclosure. References are hereunder made to the detailed descriptions and appended drawings in connection with the instant disclosure. However, the appended drawings are merely shown for exemplary purposes, rather than being used to restrict the scope of the instant disclosure.

Please refer to Figs. 1 through 3. The instant embodiment provides an LED lighting device 100 including a circuit board 1, an LED die module 2, a plurality of electronic components 3, and a packaged body 4. The packaged body 4 is integrally formed on the circuit board 1 by molding to cover the LED die module 2 and the electronic components 3. In order to realize the instant embodiment, the following description discloses the structure of each element of the LED lighting device 100, and then discloses the relationship of the elements of the LED lighting device 100.

The circuit board 1 includes a thermally conductive substrate 11, an electrically conductive layer 12, and two electrodes 13. The electrically conductive layer 12 and the electrodes 13 are disposed on the thermally conductive substrate 11. The thermally conductive substrate 11 of the instant embodiment is a ceramic substrate for example, but is not limited thereto.

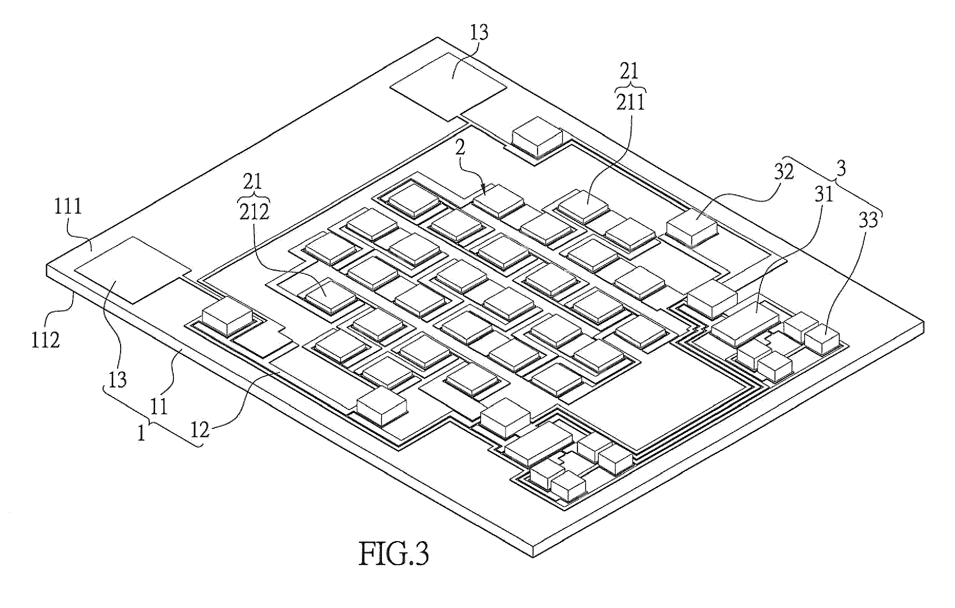

Specifically, the thermally conductive substrate 11 having a rectangular shape includes a first surface 111 (i.e., the top surface of the thermally conductive substrate 11 as shown in Fig. 3) and an opposite second surface 112 (i.e., the bottom surface of the thermally conductive substrate 11 as shown in Fig. 3). The electrically conductive layer 12 and the electrodes 13 are integrally formed as one body on the first surface 111 of the thermally conductive substrate 11. That is to say, the electrically conductive layer 12 and the electrodes 13 are exposed from the thermally conductive substrate 11.

The LED die module 2 includes a plurality of LED dies 21. The LED dies 21 are welded on the electrically conductive layer 12 so as to structurally and electrically connect to the electrically conductive layer 12. The welding manner between the LED dies 21 and the electrically conductive layer 12 adapts a metal-to-metal connection, that is to say, the electrical connection between the LED dies 21 and the electrically conductive layer 12 is achieved without wiring. For example, the metal-to-metal connection can be implemented by flip chip, reflow, ultrasonic, or surface mounting technology (SMT), but is not limited thereto.

Moreover, the LED dies 21 of the LED die module 2 provided by the instant embodiment are classified into a plurality of first LED dies 211 and a plurality of second LED dies 212 according to the color of lighting. The first LED dies 211 and the second LED dies 212 are respectively configured to emit light in different colors.

The electronic components 3 of the instant embodiment includes two LED driving components 31, a plurality of rectifying components 32 (i.e., the bridge rectifiers), and a plurality of power components 33. The type of the electronic components 3 can be changed according to the designer's request, that is to say, the type of the electronic components 3 is not limited to the instant embodiment. For example, the electronic components 3 may include linear components or non-linear components in another embodiment (not shown).

The LED driving components 31, the rectifying components 32, and the power components 33 are welded on the electrically conductive layer 12 to electrically connect to the LED die module 2 and the electrodes 3 via the electrically conductive layer 12. The two LED driving components 31 are electrically connected to the first LED die 211 and the second LED die 212, respectively, thus the lighting ratio of the first LED die 211 and the second LED die 212 is adjustable to achieve a mixing light performance by controlling the LED driving components 31.

The LED driving components 31, the rectifying components 32, and the power components 33 can be dies, or at least one of the LED driving components 31, the rectifying components 32, and the power components 33 can be packaged.

Moreover, the LED dies 21 in the instant embodiment are approximately arranged on the center region of the first surface 111 of the thermally conductive substrate 11. The LED driving components 31, the rectifying components 32, and the power components 33 are arranged around the LED dies 21. However, the above arrangement can be adjusted according to the designer's request, and is not limited to the figures of the instant embodiment. For example, the electronic components 3 can be arranged on the center region of the first surface 111, whereas the LED dies 21 are arranged around the electronic components 3 in another embodiment (not shown).

Additionally, when the LED lighting device 100 in use, the quantity of each of the LED dies 21, the LED driving components 31, the rectifying components 32, and the power components 33 can be adjusted according to the designer's request. Namely, there is one for each of the LED die 21, the LED driving component 31, the rectifying component 32, and the power component 33 in the instant embodiment. For example, when there is one LED die 21, the LED die module 2 is provided for emitting light in one color (e.g., the LED die 21 is the first LED die 211 or the second LED die 212).

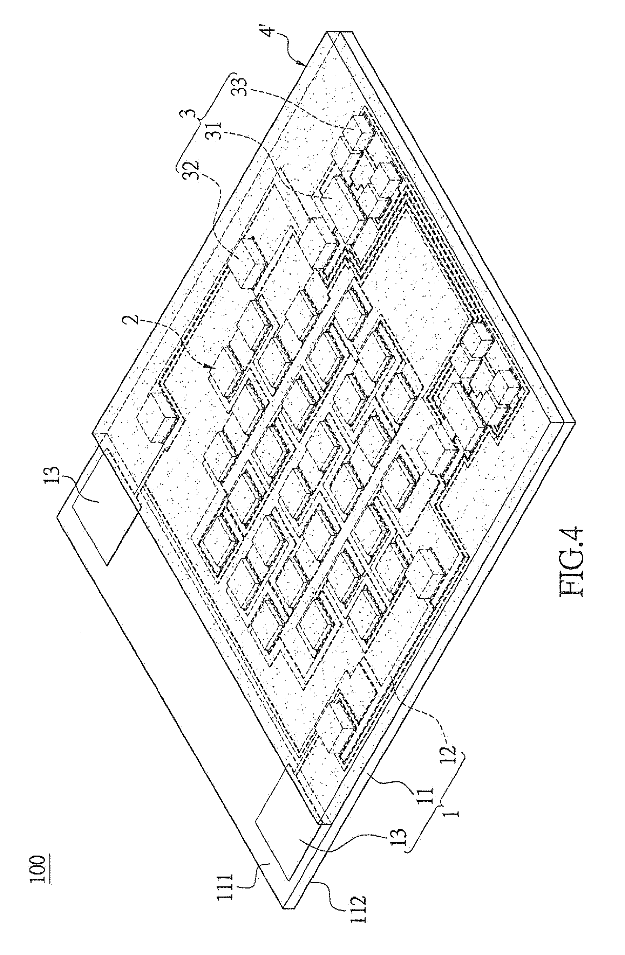

The packaged body 4 is translucent as shown in Fig. 1, but is not limited thereto. In other words, the packaged body 4 as shown in Fig. 1 can be replaced by the packaged body 4' as shown in Fig. 4. Specifically, a plurality of fluorescent powders (not labeled) is embedded in the packaged body 4' for changing the color of light emitted from the LED die module 2.

The packaged body 4 is integrally formed as one body on the first surface 111 to cover the LED die module 2, the LED driving components 31, the rectifying components 32, the power components 33, and a portion of the electrically conductive layer 12 not welded to the LED die module 2 and the electronic components 3, so that the LED die module 2 is packaged (embedded) in the packaged body 4, and the electrodes 13 are exposed from the packaged body 4.

Thus, the packaged body 4 can package the LED dies 21 to reduce cost of the LED lighting device 100, and the packaged body 4 can be configured to protect the LED die module 2, the LED driving components 31, the rectifying components 32, the power components 33, and the portion of the electrically conductive layer 12 not welded to the LED die module 2 and the electronic components 3. After the packaged body 4 is formed, the LED lighting device 100 is a finished product, which can be used directly or can be cooperated with another device, and the detail usage of the LED lighting device 100 is disclosed in the following description.

Additionally, when the LED driving components 31, the rectifying components 32, and the power components 33 are dies, the packaged body 4 is integrally formed to simultaneously package the LED dies 21, the LED driving components 31, the rectifying components 32, and the power components 33, thereby reducing the cost of the LED lighting device 100. Moreover, when the thermally conductive substrate 11 is a ceramic substrate, the packaged body 4 is preferably a molded packaged body; that is to say, the packaged body 4 is not formed by dispensing. In more detail, the supporting layer disclosed in the related art cannot be formed on the ceramic substrate, so that the packaged body 4 cannot be formed by dispensing to cover the LED dies 2 and the electronic components 3.

Specifically, the packaged body 4 is plate-like, and the top surface of the packaged body 4 is substantially parallel to the first surface 111 of the thermally conductive substrate 11. In other words, the distance between the top surface of the packaged body 4 and the first surface 111 of the thermally conductive substrate 11 is greater than the thickness of each electronic component 3, and is also greater than the thickness of each LED die 21. Moreover, the side surfaces of the packaged body 4 are not extending out of the edge of the thermally conductive substrate 11. In the instant embodiment, excluding the side surface of the packaged body 4 adjacent to the electrodes 13, the other side surfaces of the packaged body 4 are respectively coplanar and align with the adjacent edges of the thermally conductive substrate 11. However, the relationship between the packaged body 4 and the thermally conductive substrate 11 is not limited to the above description.

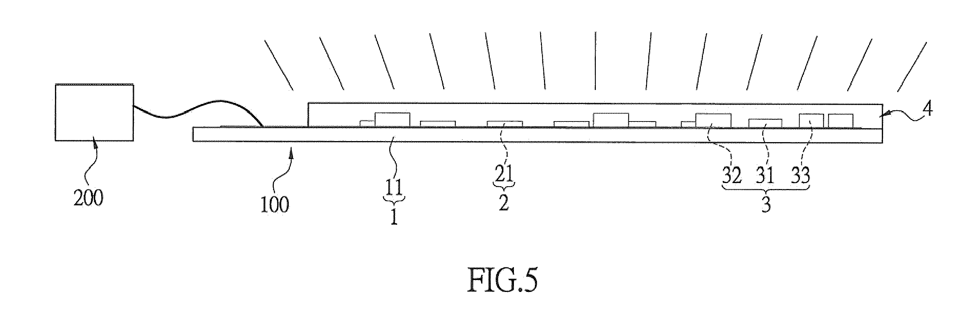

Please refer to Fig. 5. Based on the above description of the LED lighting device 100, the two electrodes 13 are configured to electrically connect to an external power source 200 (i.e., the commercial socket) by cables (not labeled) for transmitting electrical power (i.e., the AC power) generated from the external power source 200 (i.e., the commercial socket) through the electrically conductive layer 12, the LED driving components 31, the rectifying components 32, and the power components 33 to turn on the LED die module 2. However, the LED lighting device 100 as shown in Fig. 5 is a finished product, which is one of the possible embodiments, but the LED lighting device 100 is not limited to Fig. 5.

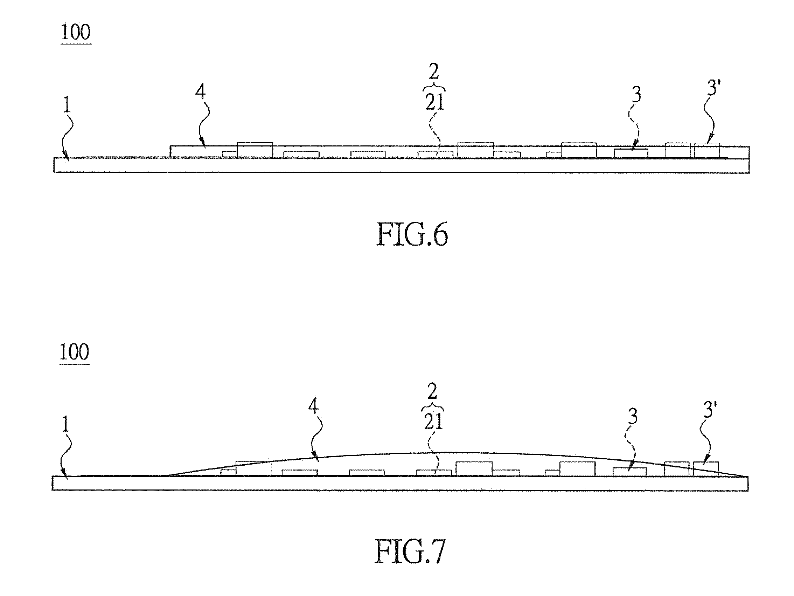

Additionally, when some of the electronic components 3 of the LED lighting device 100 have been packaged and before the packaged body 4 is formed, the packaged electronic components 3' need not to be entirely covered by the packaged body 4 (as shown in Figs. 6 and 7). Specifically, as shown in Fig. 6, the thickness of the packaged body 4 formed by molding can be reduced, and the thickness of the packaged body 4 large enough to entirely cover the LED die module 2 and the non-packaged electronic components 3, whereas the top portion of the packaged electronic components 3' are exposed from the packaged body 4. Moreover, as shown in Fig. 7, the packaged body 4 can be formed by dispensing to shape the top surface of the packaged body 4 in arc-shaped. The packaged electronic components 3' are arranged at the outer and thinner portion of the packaged body 4 in order to be exposed from the packaged body 4, while the LED die module 2 and the non-packaged electronic components 3 are arranged at the center portion of the packaged body 4 to be entirely covered and packaged.

### [Second Embodiment]

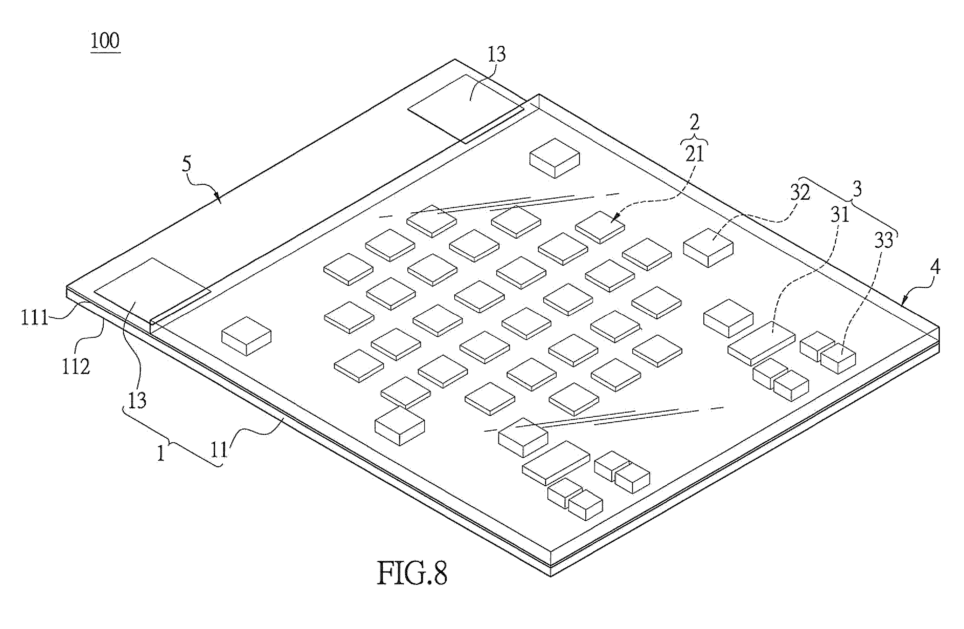

Please refer to Fig. 8, which shows a second embodiment of the instant disclosure. The instant embodiment is similar to the first embodiment, and the identical features are not disclosed. The main difference between the instant embodiment and the first embodiment is the LED lighting device 100 of the instant embodiment, in which the LED lighting device 100 of the instant embodiment has a light reflecting layer 5.

Specifically, the electrically conductive layer 12 is formed on the first surface 111 of the thermally conductive substrate 11, and the light reflecting layer 5 covers the first surface 111 and portions of the electrically conductive layer 12. The light reflecting layer 5 does not cover the two electrodes 13 and a portion of the electrically conductive layer 12 used for welding the LED die module 2 and the electronic components 3. The LED die module 2 and the electronic components 3 are welded on the portion of electrically conductive layer 12, which is not covered by the light reflecting layer 5. In other words, the LED die module 2 and the electronic components 3 protrude from the light reflecting layer 5. Moreover, the packaged body 4 covers the light reflecting layer 5, the LED die module 2, and the electronic components 3.

### [Third Embodiment]

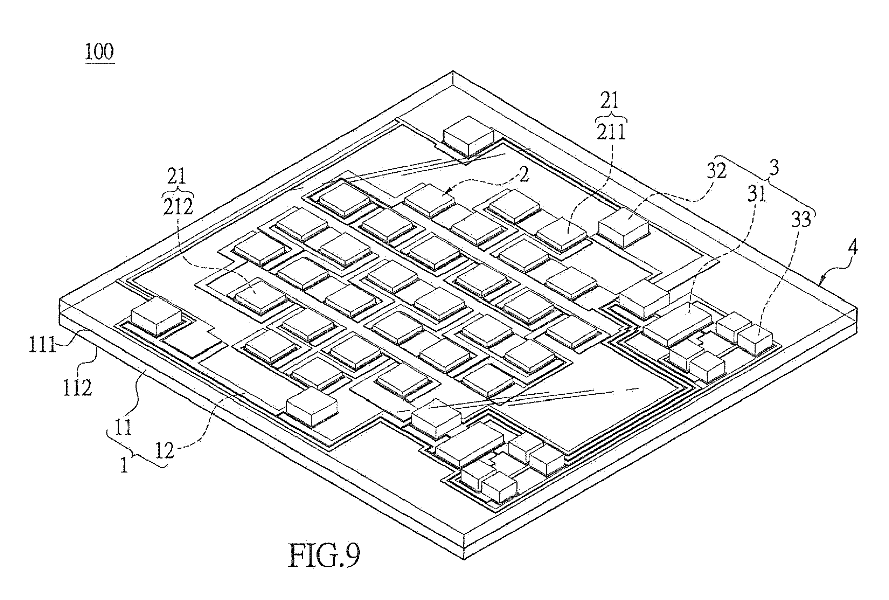

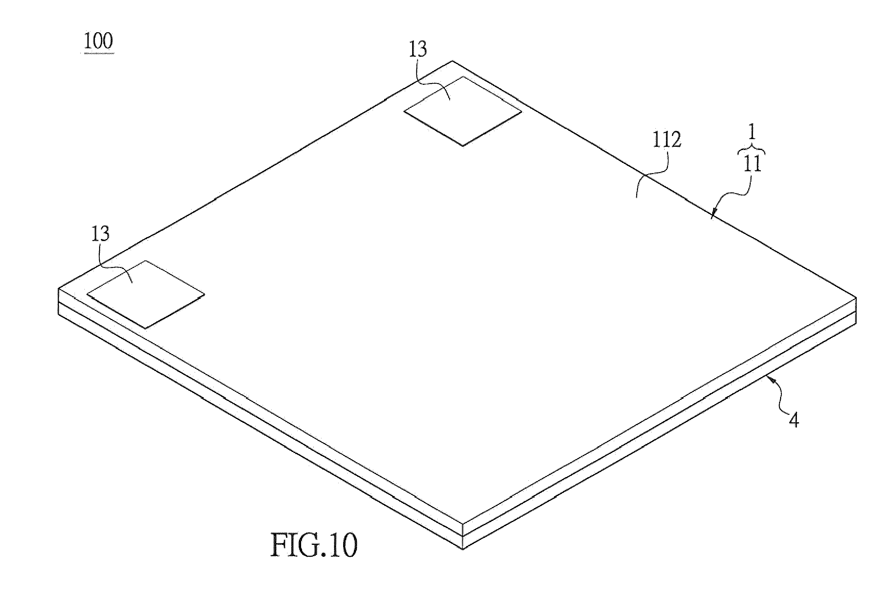

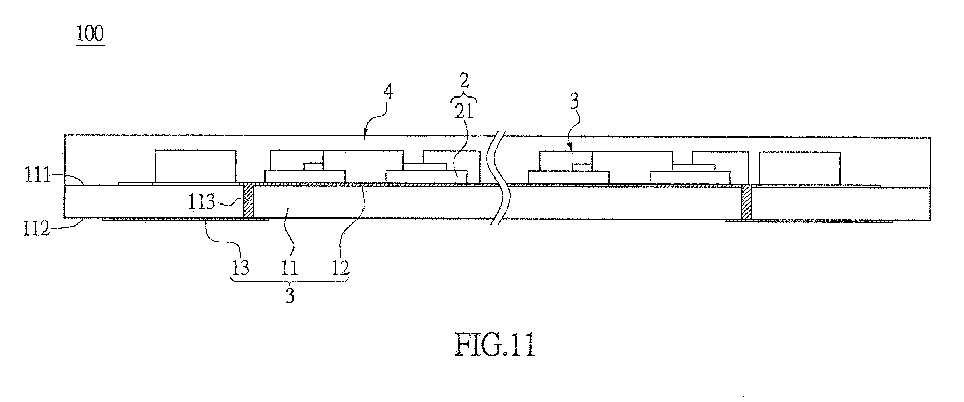

Please refer to Figs. 9 through 12, which show a third embodiment of the instant disclosure. The instant embodiment is similar to the first embodiment, and the identical features are not disclosed. The main difference between the instant embodiment and the first embodiment is the electrodes 13 of the instant embodiment, in which the electrodes 13 of the instant embodiment are disposed on the second surface 112 of the thermally conductive substrate 11.

Please refer to Figs. 9 through 11. The size of the thermally conductive substrate 11 of the instant embodiment can be reduced with respect to the first embodiment. In the instant embodiment, the electrodes 13 disposed on the second surface 112 of the thermally conductive substrate 11 are electrically connected to the electrically conductive layer 12. The electrical connection between the electrodes 13 and the electrically conductive layer 12 is achieved by the following manner. The thermally conductive substrate 11 has two thru-holes 113 penetrated through both the first surface 111 and the second surface 112, and two ends of the thru-hole 113 respectively correspond to one electrode 13 and the electrically conductive layer 12. The thru-holes 113 are filled with conductive material (not labeled), such that the electrodes 13 are electrically connected to the electrically conductive layer 12 via the conductive material filled in the thru-holes 113.

Specifically, the edges of the packaged body 4 of the instant embodiment respectively align with the edges of the first surface 111. That is to say, the four side surfaces of the packaged body 4 are respectively coplanar with the four side surfaces of the thermally conductive substrate 11. Thus, the LED lighting device 100 of the instant embodiment can be made smaller and has a more pleasing appearance. The electrodes 13 are formed on the second surface 112 of the thermally conductive substrate 11, so that when the LED lighting device 100 is assembled with a mating device, a region of the mating device provided for mounting the LED lighting device 100 can directly and electrically connected to the electrodes 13. The LED lighting device 100 can be installed on the mating device by welding, screwing, wedging, or adhering, but is not limited thereto.

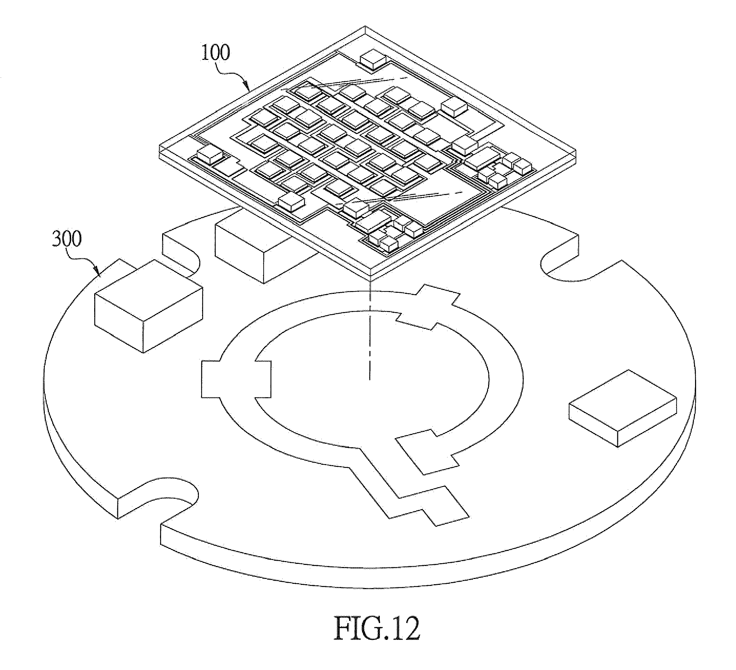

For example, as shown in Fig. 12, the LED lighting device 100 of the instant embodiment is fixed on and electrically connected to a functional heat-dissipating board 300. The functional heat-dissipating board 300 is provided for adjusting light emitted from the LED die module 2 of the LED lighting device 100 or applying the LED die module 2, thus the LED lighting device 100 can be used according to different requests. Moreover, the LED lighting device 100 of the instant embodiment can be electrically connected to the external power source by cables as disclosed in the first embodiment (not shown), or the LED lighting device 100 of the instant embodiment can be provided with the light reflecting layer 5 (not shown).

Additionally, the thermally conductive substrate 11 of the instant embodiment is preferably a ceramic substrate, but not a metallic substrate due to the difficulty in forming electrodes on the metallic substrate. However, the material of the thermally conductive substrate 11 is not limited ceramic substrates.

### [The possible effect of the above embodiments]

In summary, the LED lighting device of the instant disclosure includes the packaged body that can package the LED dies and protect the LED die module, the LED driving components, the rectifying components, the power components, and the portion of the electrically conductive layer not welded to the LED die module and the electronic components 3, thereby reducing the cost of the LED lighting device. The LED lighting device can directly and electrically connect to the external power source for lighting.

Moreover, when the LED driving components, the rectifying components, and the power components are dies, the packaged body can package the LED dies, the LED driving components, the rectifying components, and the power components by molding, thereby reducing the packaging cost of the LED lighting device.

Additionally, the LED lighting device of the instant disclosure can be minimized and be applied in a lot of manners by forming the electrodes on the second surface of the thermally conductive substrate.

The descriptions illustrated *supra* set forth simply the preferred embodiments of the instant disclosure; however, the characteristics of the instant disclosure are by no means restricted thereto. All changes, alternations, or modifications conveniently considered by those skilled in the art are deemed to be encompassed within the scope of the instant disclosure delineated by the following claims.

## Claims

1. An LED lighting device, comprising:
a circuit board (1) having a thermally conductive substrate (11), an electrically conductive layer (12), and two electrodes (13) disposed on the thermally conductive substrate (11), wherein the thermally conductive substrate (11) has a first surface (111) and an opposite second surface (112), the electrically conductive layer (12) disposed on the first surface (111), the two electrodes (13) electrically connect to the electrically conductive layer (12);
an LED die module (2) welded on the electrically conductive layer (12);
an LED driving component (31) welded on the electrically conductive layer (12), wherein the LED driving component (31) electrically connects to the LED die module (2) and the electrodes (13) via the electrically conductive layer (12); and
a translucent packaged body (4) formed as one body, wherein the packaged body (4) is integrally formed on the first surface (111) to cover the LED die module (2) and the LED driving component (31), and the LED die module (2) is packaged in the packaged body (4);
wherein the two electrodes (13) are configured to electrically connect to an external power source (200) for transmitting electrical power generated from the external power source (200) through the electrically conductive layer (12) and the LED driving component (31) to the LED die module (2).

2. The LED lighting device as claimed in claim 1, further comprising a rectifying component (32) welded on the electrically conductive layer (12) and packaged in the packaged body (4).

3. The LED lighting device as claimed in claim 2, further comprising:
a power component (33) welded on the electrically conductive layer (12), wherein the packaged body (4) covers a portion of the electrically conductive layer (12) not welded to the LED die module (2), the LED driving component (31), the rectifying component (32), and the power component (33), wherein the two electrodes (13) are configured to electrically connect to a commercial socket (200) for transmitting AC power generated from the commercial socket (200) through the electrically conductive layer (12), the LED driving component (31), the rectifying component (32), and the power component (33) to the LED die module (2).

4. The LED lighting device as claimed in claim 3, wherein at least one of the LED driving component (31), the rectifying component (32), and the power component (33) is a die packaged in the packaged body (4), wherein the packaged body (4) is a molded packaged body.

5. The LED lighting device as claimed in claim 1, wherein the electrodes (13) are formed on the first surface (111) and are exposed from the thermally conductive substrate (11), wherein the packaged body (4) covers the electrically conductive layer (12).

6. The LED lighting device as claimed in claim 1, wherein the electrodes (13) are formed on the first surface (11), the LED lighting device further comprising:
a light reflecting layer (5) disposed on the first surface (111) and part of the electrically conductive layer (12), wherein the LED die module (2) and the LED driving component (31) are welded on a portion of the electrically conductive layer (12) not covered by the light reflecting layer (5), the LED die module (2) and the LED driving component (31) protrude from the light reflecting layer (5), wherein the packaged body (4) covers at least part of the light reflecting layer (5).

7. The LED lighting device as claimed in claim 1, wherein the LED die module (2) includes a first LED die (211) and a second LED die (212), and the first LED die (211) and the second LED die (212) are configured to emit light in different colors.

8. The LED lighting device as claimed in claim 1, wherein a plurality of fluorescent powders is embedded in the packaged body (4) for changing the color of light emitted from the LED die module (2).

9. The LED lighting device as claimed in claim 1, wherein the thermally conductive substrate (11) is a ceramic substrate, wherein the electrodes (13) are disposed on the second surface (112), wherein the edge of the packaged body (4) is substantially aligned with the edge of the first surface (111).

10. An LED lighting device, comprising:
a circuit board (1) having a thermally conductive substrate (11), an electrically conductive layer (12), and two electrodes (13) disposed on the thermally conductive substrate (11), wherein the thermally conductive substrate (11) has a first surface (111) and an opposite second surface (112), the electrically conductive layer (12) disposed on the first surface (111), the two electrodes (13) electrically connect to the electrically conductive layer (12);
an LED die module (2) welded on the electrically conductive layer (12);
an electronic component (3) being a die, the electronic component (3) welded on the electrically conductive layer (12), wherein the electronic component (3) electrically connects to the LED die module (2) and the electrodes (13) via the electrically conductive layer (12); and
a translucent packaged body (4) formed as one body, wherein the packaged body (4) is integrally formed on the first surface (111) to cover the LED die module (2) and the electronic component (3), wherein the LED die module (2) and the electronic component (3) are packaged in the packaged body (4).
